# EUROPEAN PATENT APPLICATION

(11) **EP 2 688 374 A1**
(43) Date of publication of application: **22.01.2014**
(21) Application number: 12866400.0
(22) Date of filing: 30.05.2012
(51) Int. Cl.: H05K 1/18, H01R 4/02, H01R 4/38

(54) **WIRING SUBSTRATE**

(71) Applicant: Sanyo Electric Co., Ltd., Moriguchi-shi, Osaka 570-8677 (JP)
(72) Inventor: SAITO, Takao, Moka City Tochigi 321-4397 (JP); OHSHIMA, Makoto, Moka City Tochigi 321-4397 (JP)
(74) Representative: Glawe, Delfs, Moll
(86) International application number: PCT/JP2012/063837
(87) International publication number: WO 2013/179403

(57) **Abstract**

[Problem] To provide a printed circuit board in which it is possible to decrease generation of heat in a terminal block mounted on the printed circuit board.

[Solution] A printed circuit board (10) comprising: a printed wiring (11); a terminal block (13) configured by folding a solderable plate member having a foot (31); a soldered part (14) for connecting the printed wiring (11) and the terminal block (13) arranged on the printed wiring; and a through-hole (12) provided to the soldered part (14), for insertion of the foot (31); the foot (31) being inserted into the through-hole (12) and connected by soldering; the printed circuit board comprising a solderable metal wire (17) arranged on the soldered part (14) along the terminal block (13); the soldered part (14), the terminal block (13), and the metal wire (17) being integrally soldered during soldering by solder fed through the through-hole (12).

## Description

### TECHNICAL FIELD

The present invention relates to a printed circuit board in which a terminal block has been connected by soldering onto a printed wiring.

### BACKGROUND ART

In the past, there have been provided printed circuit boards in which a printed wiring is provided, and the connection wire of an electronic component such as a resistor or a capacitor is inserted into a through-hole provided to the printed wiring and soldered to form an electrical circuit. Such printed circuit boards are manufactured so as to constitute a variety of electrical circuits according to the electronic equipment. In a moderately large device, a plurality of printed circuit boards are provided, and the printed circuit boards are linked by a wire or the like to form an electrical circuit.

Thus, in such an instance in which a plurality of printed circuit boards are linked by a wire, if the wires linking the printed circuit boards are to handle heavy currents, such as in the instance of power lines provided in order to supply electrical power, the wire will be thicker; therefore, an innovation is necessary in order to connect the wire to the printed circuit board. Specifically, a terminal block is provided to the printed circuit board and the wire is connected to the terminal block.

There have been provided a variety of methods for soldering electronic components to the printed circuit board. In the method shown in Patent Citation 1, a jumper wire (metal wire) is provided along the connection wire of an electronic component in the vicinity of a through-hole into which the connection wire is inserted, and the printed circuit board is dipped into a molten solder pool and soldering is performed. The jumper wire and the connection wire of the electronic component are thereby soldered on the reverse surface of the surface on which the jumper wire and the electronic component are arranged (defined as the obverse surface), and the electronic component can be firmly mounted on the printed circuit board.

Patent Citation 1: JP-A 2001-332848

### DISCLOSURE OF THE INVENTION

### [Problems the Invention Is Intended To Solve]

However, if an electronic component is soldered as disclosed in Patent Citation 1, the jumper wire and the connection wire of the electronic component are connected by soldering on the reverse surface, but the jumper wire and the electronic component are not connected on the obverse surface. Therefore, if this technique is applied to a terminal block, the connection wire of the terminal block is merely soldered on the reverse surface of the printed circuit board. In such an instance, a problem will be presented in that there will be a location at which the current supplied to the terminal block flows through the foot of the terminal block only, causing the narrow-section of the current path to be smaller, and the amount of heat to be greater, at this location.

The present invention has been conceived in light of the abovementioned problem, it being an object thereof to provide a printed circuit board in which generation of heat in a terminal block mounted on the printed circuit board can be decreased.

### [Means for Solving the Abovementioned Problems]

In order to achieve the abovementioned object, the present invention is a printed circuit board comprising: a printed wiring; a terminal block configured by folding a solderable plate member, the terminal block having a foot; a soldered part for connecting the printed wiring and the terminal block arranged on the printed wiring; and a through-hole provided to the soldered part, for insertion of the foot; the foot being inserted into the through-hole and connected by soldering; the printed circuit being characterized in comprising a solderable metal wire arranged on the soldered part along the terminal block; and the soldered part, the terminal block, and the metal wire being integrally soldered during soldering by solder fed through the through-hole.

According to the printed circuit board of the present invention, soldering causes the solder to be charged into the through-hole; and the soldered part, the terminal block, and the metal wire are connected by soldering. Paths through which a current flows to the terminal block, and to the terminal block through the solder (and/or the metal wire), from not only the foot of the terminal block but also from the soldered part, are thereby formed. As a result, the narrow-section of the current path can be increased, and generation of heat can therefore be decreased.

The above-mentioned invention is further characterized in that the metal wire is arranged so as to straddle the through-hole.

The above-mentioned invention is further characterized in that the terminal block has a plurality of feet; the through-holes are provided so as to respectively face the feet; and the metal wire is arranged so as to straddle a plurality of the through-holes.

The above-mentioned invention is further characterized in that at least two of the metal wires are provided, and the two metal wires are provided at positions that face each other across the terminal block.

### [Effect of the Invention]

According to the present invention, it is possible to provide a printed circuit board in which less heat is generated in a terminal block mounted on the printed circuit board.

### BRIEF DESCRIPTION OF THE DRAWINGS

FIG. 1 is an exploded perspective view of a terminal block portion of the printed circuit board;
FIG. 2 is a perspective view of the terminal block portion of the printed circuit board to which the terminal block has been mounted; and
FIG. 3 shows the soldered part of the printed circuit board.

### BEST MODE FOR CARRYING OUT THE INVENTION

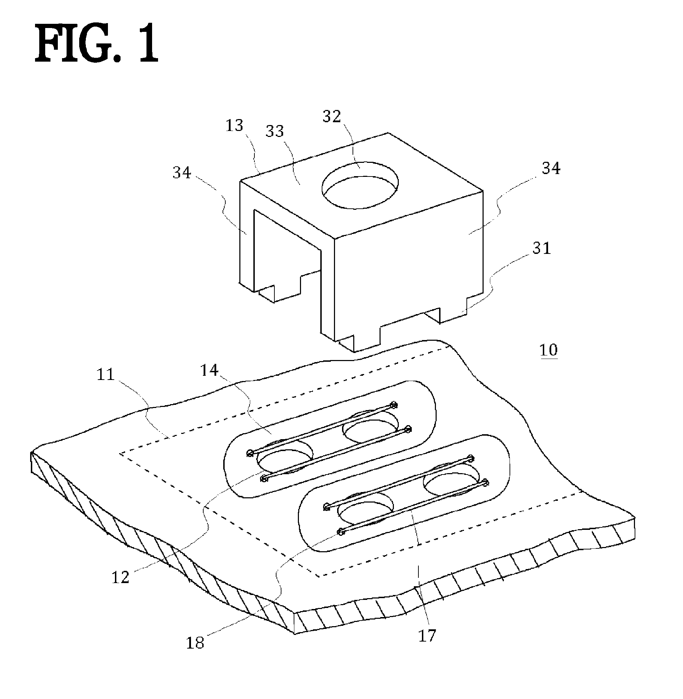

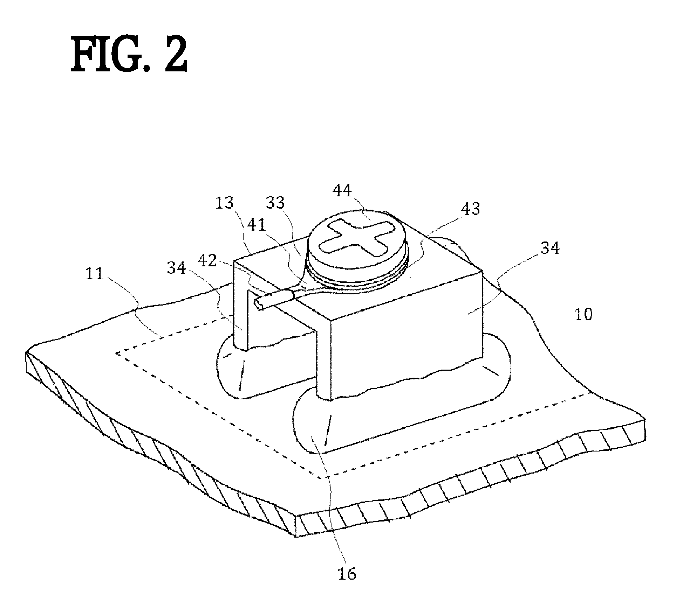

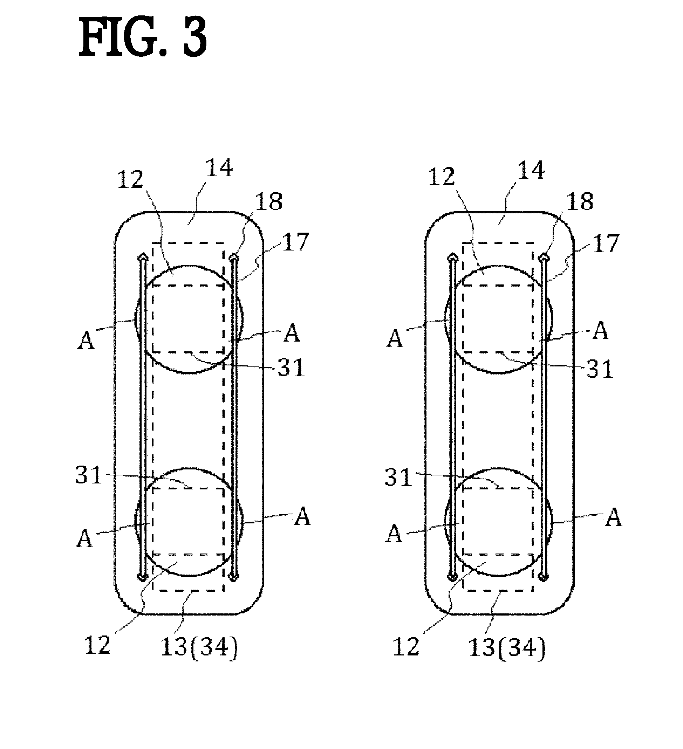

An embodiment of the present invention will now be described in detail with reference to the drawings. FIG. 1 is an exploded perspective view of a terminal block portion of a printed circuit board. FIG. 2 is a perspective view of the terminal block portion of the printed circuit board to which the terminal block has been mounted. FIG. 3 shows the soldered parts of the printed circuit board. A printed circuit board 10 is provided with: a printed wiring 11, a through-hole 12, a terminal block 13, soldered parts 14, jumper wires 17 (metal wires), and an electronic component (not shown).

The printed circuit board 10 is provided with a printed wiring 11 in which: through-holes 12 having, e.g., a round shape are formed in a portion at which the electronic component, the terminal block 13, and the like are to be arranged; and the electronic component, the terminal block 13, and the like are arranged and connected by soldering, thereby forming a predetermined electrical circuit. A resist is applied from above the printed wiring 11 onto the printed circuit board 10, other than around the through-holes 12. Soldered parts 14, in which the printed wiring 11 is exposed, are formed around the through-holes 12. In other words, the through-holes 12 are provided to the soldered parts 14 in the printed wiring 11. In FIGS. 1 and 2, the printed wiring 11 is covered by the resist, and is therefore indicated by a dotted line. The shape of the through-holes is not limited to being ellipsoidal, polygonal, or another shape; it is sufficient only that the shape allows a foot to be inserted with a gap being present. An inner wall of the printed circuit board 10 in which are formed the through-holes 12 is coated by a solderable material, similar to that for the printed wiring 10.

The terminal block 13 comprises a metal that can be soldered (e.g., aluminum). The terminal block 13 has a cross-sectional C-shape in which both ends of a rectangular plate member are folded and two side surfaces 34 and an upper surface 33 are formed. Two feet 31 protruding downwards (i.e., towards the printed circuit board) are provided on the lower side of either side surfaces of the terminal block 13. A screw hole 32 is provided to the upper surface of the terminal block 13. Using a screw 44, a wire having, e.g., a U-shaped terminal or a circular terminal can be sandwiched between the screw 44 and the terminal block and secured. In FIG. 2, a wire 42 having a circular terminal 41 is secured by a screw, a ring washer 43 being interposed therebetween.

Two soldered parts 14 are formed so that each of both side surfaces 34 of the terminal block 13 can be respectively arranged thereon. The through-holes 12 in the soldered parts 14 face the feet 31 provided to the side surfaces 34 of the terminal block 13, and the feet 31 are provided respectively to each corresponding location (i.e., the same number of feet 31 are provided). The feet 31 of the terminal block 13 are inserted into the through-holes 12, and both side surfaces 34 are arranged on the respective soldered parts 14. The diameter of the through-holes 12 is greater than the thickness of the terminal block 13. The side surfaces 34 of the terminal block 13 are arranged so as to straddle the center portions of the through-holes 12.

The jumper wires 17 comprise a metal that can be soldered. The jumper wires 17 are arranged on the soldered parts 14 so as to completely straddle two through-holes 12 along the terminal block 13 (see FIG. 3). Two jumper wires may also be provided so as to straddle each of the two through-holes. The dotted lines in FIG. 3 indicate the side surfaces 34 of the terminal block 13 arranged on the soldered parts 14. Two jumper wires 17 are provided at positions that face each other across the terminal block 13, and each of the jumper wires 17 is arranged so as to straddle both edge parts of the through-holes. Both ends of the jumper wires 17 are inserted into holes 18 provided on the soldered parts 14 and the jumper wires 17 are secured.

After the terminal block 13 and the jumper wires 17 have been arranged on the printed circuit board 10, the surface of the printed circuit board 10 on which the components are arranged and the reverse surface on the opposite side are dipped in a molten solder pool, and soldering is performed. This soldering causes solder 16 to be charged into the through-holes 12 from the reverse-surface side. The solder 16 is fed through the through-holes 12 to the soldered parts 14 on the obverse surface of the printed circuit board 10 from gaps A (gaps A that are not blocked by the terminal block 13 in the through-holes 12) formed by the terminal block 13 partially (rather than completely) straddling the through-holes 12. The terminal block 13, the soldered parts 14, and the jumper wires 17 are thereby connected by soldering to each other by the solder 16 (see FIG. 2).

When the melted solder 16 adheres to the jumper wires 17 straddling the gaps A, the adhered melted solder 16 spreads along the jumper wires 17, allowing a greater amount of the solder 16 to be fed from the reverse surface to the soldered parts 14 on the obverse surface.

Since the jumper wires 17 are arranged along the side surfaces 34 of the terminal block 13, the solder 16 can be fed to the terminal block 13. Also, since the terminal block 34 straddle the vicinity of the center of the through-holes 12, and the jumper wires straddle both edge parts of the through-holes 12, solder is fed to the terminal block 13 from both sides, where the jumper wires 17 have been arranged.

Thus, a configuration is present in which solder can be fed from the reverse surface to the obverse surface of the printed circuit board 10; therefore, it is possible to avoid or mitigate situations in which the feeding of the solder to the obverse surface is insufficient and there is a need to manually apply additional solder. The number of soldering steps can thereby be reduced, increasing production efficiency.

Thus, the through-holes 12, the holes A, and the jumper wires 17 are provided to the same soldered parts 14, the terminal block 13 is arranged on the soldered parts 14, and soldering is performed. The soldered parts 14, the terminal block 13, and the jumper wires 17 are thereby integrally soldered by the solder 16 fed through the through-holes 12. The printed wiring 11 and the terminal block 13 are then connected to each other. Then, [a connection is established with] another printed circuit board 10 to which a terminal block 13 has been similarly soldered, by connecting the terminal blocks 13 together using a wire, and an electronic circuit of a device is formed. This printed circuit board 10 can be used for a motor driving device or a grid interconnection device having a power line such as a booster circuit or an inverter circuit.

As described above, according to the present embodiment, the soldering feeds the solder 16 through the through-holes 12 to the side of the terminal block 13, and makes it possible to integrally solder the soldered parts 14, the terminal block 13, and the jumper wires. In this event, the jumper wires straddling the through-holes draw the solder up through the gaps present in the through-holes. Therefore, in essence, solder is applied to the soldered parts 14 along the terminal block 13 towards the side of the upper surface 33 of the terminal block 13, and the soldering strength of the terminal block 13 soldered to the printed circuit board 10 is thereby enhanced. This applied solder forms a path through which a current is delivered to the terminal block 13 without passing through the feet 31. Therefore, the narrow-section of the current path can be increased, and generation of heat in the terminal block 13 can be decreased.

Also, according to the present embodiment, the jumper wires 17 are provided so as to completely straddle two through-holes 12. Therefore, the solder rising from one of the through-holes 12 is transmitted along the jumper wires 17 to the other through-hole 12, whereby the transmitted solder acts as a primer for solder to be fed to the obverse surface of the printed circuit board 10 through the other through-hole 12.

Although a description of an embodiment of the present invention has been given above, the description given above is intended to facilitate understanding of the present invention, and is not intended to limit the present invention. It shall be apparent that the present invention may be modified or improved without departing from the scope thereof, and that the present invention includes equivalents thereof.

For example, in the present embodiment, each of the jumper wires 17 is arranged so as to straddle all (i.e., both) of the through-holes 12. However, each of the jumper wires 17 may be arranged so as to respectively straddle each of the through-holes. Thus, soldering can be performed using short jumper wires 17, even when the distance between the through-holes 12 is larger, and the jumper wires can be more readily arranged on the printed circuit board 10.

Also, in such an instance, if there is distance between a plurality of through-holes 12, jumper wires may be provided between each of the jumper wires 17 which have been arranged. Solder is thereby fed, along the jumper wires 17 provided in the vicinity of the through-holes 12, to the jumper wires arranged between the jumper wires 17. Therefore, the terminal block 13 and the soldered parts 14 can be connected by soldering without there being any unevenness.

Also, for example, a solder paste may be arranged on the through-holes 12 along the positions at which the side surfaces 34 of the terminal block 13 are arranged; whereupon the terminal block 13 is arranged and soldering is performed. The arranged solder paste thereby melts, and solder rising from the solder pool is drawn up by the melted solder paste, when soldering is performed in the solder pool. In addition, the solder paste is also used for soldering the terminal block 13 and the soldered parts 14 to each other; therefore, a greater amount of solder can be fed to the terminal block 13 without there being any unevenness.

### [Key to Symbols]

- 10: printed circuit board
- 11: printed wiring
- 12: through-hole
- 13: terminal block
- 14: soldered part
- 16: solder
- 17: jumper wire (metal wire)
- 18: hole
- 31: foot
- 32: screw hole
- 33: upper surface of terminal block
- 34: side surface of terminal block
- A: gap

## Claims

1. A printed circuit board comprising:
a printed wiring;
a terminal block configured by folding a solderable plate member, the terminal block having a foot;
a soldered part for connecting the printed wiring and the terminal block arranged on the printed wiring; and
a through-hole provided to the soldered part, for insertion of the foot;
the foot being inserted into the through-hole and connected by soldering;
the printed circuit board being **characterized in** comprising a solderable metal wire arranged on the soldered part along the terminal block; and
the soldered part, the terminal block, and the metal wire being integrally soldered during soldering by solder fed through the through-hole.

2. The printed circuit board according to claim 2, **characterized in that** the metal wire is arranged so as to straddle the through-hole.

3. The printed circuit board according to claim 2, **characterized in that**:
the terminal block has a plurality of feet;
the through-holes are provided so as to respectively face the feet; and
the metal wire is arranged so as to straddle a plurality of the through-holes.

4. The printed circuit board according to any of claims 1 through 3, **characterized in that** at least two of the metal wires are provided, and the two metal wires are provided at positions that face each other across the terminal block.

## Amended claims

### Amended claims under Art. 19.1 PCT

1. A printed circuit board comprising:
a printed wiring being provided on the surface of the printed circuit board on the side of which a terminal block is mounted;
the terminal block configured by folding a solderable plate member to form a side surface from which a foot is protruded and is inserted into a through hole being provided in the printed wiring, and securing a terminal of a wire to a screw hole being provided on the upper surface of the terminal block by using a screw;
the printed wiring being provided with a soldered part for soldering the foot inserted into the through hole;
a solderable metal wire being arranged, on the side onto which the terminal block is mounted, so as to straddle the through-hole;
the metal wire and the side surface being integrally soldered by solder fed from the opposite side, onto which the terminal block is mounted, of the printed circuit board through the through-hole.

2. The printed circuit board according to claim 1, **characterized in that**:
the terminal block has a plurality of feet;
the through-holes are provided so as to respectively face the feet; and
the metal wire is arranged in a straight fashion so as to straddle a plurality of the through-holes.

3. The printed circuit board according to any of claims 1 through 2, **characterized in that** at least two of the metal wires are provided, and the two metal wires are provided at positions that face each other across the terminal block.

4. The printed circuit board according to claim 3, **characterized in that** the through-hole and the foot have different shapes from each other.
